# EUROPEAN PATENT SPECIFICATION

(11) **EP 2 718 767 B1**
(45) Date of publication and mention of the grant of the patent: **07.08.2019**
(21) Application number: 12730429.3
(22) Date of filing: 11.06.2012
(51) Int. Cl.: G03F 7/42, C23G 5/024

(54) **COMPOSITION OF SOLUTIONS AND CONDITIONS FOR USE ENABLING THE STRIPPING AND COMPLETE DISSOLUTION OF PHOTORESISTS**
ZUSAMMENSETZUNG AUS LÖSUNGEN UND BEDINGUNGEN ZUR VERWENDUNG ZUR ABISOLIEREUNG UND VOLLSTÄNDIGEN AUFLÖSUNG VON FOTOLACKEN
COMPOSITION DE SOLUTIONS ET CONDITIONS D'UTILISATION PERMETTANT L'ÉLIMINATION ET LA DISSOLUTION COMPLÈTE DE RÉSINES PHOTOSENSIBLES

(30) Priority: 09.06.2011 FR 1101779
(43) Date of publication of application: 16.04.2014
(73) Proprietor: Technic France, 93200 Saint Denis (FR)
(72) Inventor: DAVIOT, Jérôme, F-71100 Chalon sur Saône (FR); VERNIN, Philippe, F-93200 Saint Denis (FR)
(74) Representative: Regimbeau
(86) International application number: PCT/EP2012/061037
(87) International publication number: WO 2012/168485

(56) References cited:
- EP-A2- 1 860 508
- WO-A1-2010/060273
- US-A- 5 571 447
- US-A1- 2004 127 374
- US-B2- 7 129 029

## Description

The present invention relates to the composition of a cleaning formulation dedicated to the complete and selective stripping of photoresists of all thicknesses used in microelectronic component integration processes (metal interconnections, copper pillars, TSV). Said solution is optimized to strip and/or dissolve the polymer matrix, which constitutes the resin, while ensuring and protecting the physicochemical integrity of exposed materials such as metal interconnections (copper, aluminum), dielectrics (SiO₂, MSQ, etc.) and diffusion and adhesion barriers (TiN, Ti, Ta, TaN, etc.).

The fabrication of integrated circuits involves a consequent number of steps, a large percentage of which comprise successive series of depositions of electroconductive, resistant and/or semiconductor layers, uniform masking of the surface by photopolymers, exposure and development of the resin. The primary function of the photopolymer is to protect certain zones while selectively exposing others. It can thus be envisaged on these surfaces of exposed material to subsequently undertake steps of wet and/or dry selective deposition and/or etching. These selective and successive steps make it possible to construct a three-dimensional network whose complexity and multiplicity will define the final functionality of the microelectronic elements (flash memory, microchips, connectors, decoders, analog converters, graphics cards, etc.). Nevertheless, after all these fabrication steps, resin present on the surface must be stripped completely in order to ensure optimal surface quality, devoid of all residual debris which can cause defects and changes in the quality and performance of subsequent integration steps. Additionally, in a number of cases, these resins must be stripped while materials that are vulnerable from an electrochemical point of view remain exposed. The materials most likely to sustain chemical attack or corrosion during the resin stripping process are metals such as aluminum and copper, used specifically for intra- and inter-level connections (interconnections, pillars, TSV).

In order to ensure the optimal and maximal operation of the microelectronic component, a resin stripping formulation must be highly effective and have properties not only of polymer matrix dissolution but also of compatibility with materials comprising the microelectronic circuit.

Among the many resin stripping chemicals available on the market, mention can be made of:
- Mixtures of polar aprotic solvents such as DMSO (dimethylsulfoxide) and NMP (N-methylpyrrolidone) in an alkaline medium, TMAH (tetramethylammonium hydroxide; US 2011/0000874; US 6,551,973; US 6,040,117), alkanolamine (US 5,507,978; US 6,071,868; US 5,308,745) and additives such as corrosion inhibitors, surfactants and cosolvents (US 2007/0078072).
- Alkaline solutions containing hydroxylamine and a co-amine in the presence of a corrosion inhibitor such as polyhydroxyl benzene compounds, i.e., catechol, pyrogallol, etc. (US 5,334,332, US 6,225,034).
- Solutions of organic amines with solvents such as glycol, alcohol or ether (US 4,744,834, US 6,071,868).
- Formulations in a non-polar medium such as a petroleum fraction containing surfactants such as DDBSA (dodecylbenzene sulfonic acid) and nonylphenol (US 4,992,108; US 6,475,292; US 5,863,346).
- Mixtures of organic solvents such as gamma-butyrolactone, ethylene lactate, NMP, cyclopentanone, dioxolane, polyglycol, dibasic ester (US 5,909,744), etc.

This great diversity of resin stripping solutions is in harmony with the immense variety of resins used in the fabrication of electronic components. In the case of applications requiring the formation of complex structures deposited on a substrate, the thickness of the resin to be removed can vary from 1 to 300 microns. During this study, none of the chemical approaches cited above were effective in completely dissolving semi-novolac resins at temperatures between 40 and 100°C. However, professionals increasingly require that resin stripping solutions be effective at temperatures below 100°C, advantageously below 75°C. It is furthermore required that resin is completely dissolved in solutions in order to enable the recirculation of said solutions without premature clogging of the particulate filters typically installed in equipment dedicated to this operation.

In the prior act, some formulations enabling the stripping of photoresists are disclosed.
WO 2010/060273 patent application discloses a formulation which includes a quantity of water above 1% by mass in relation to the total weight of the formulation.
EP 1 860 508 patent application discloses a formulation which comprises a solvent blend of at least three discrete solvents: glycolether and/or alcoholblend, and optionally organic solvent.
US 2004/127374 patent application discloses a formulation comprising 10% to about 99% by weight of a glycolether compound, 0,1% to about 10 by weight of an alkylbenzenesulfonic and about 0,5% to about 5% by weight of a corrosion inhibitor.
US 5 571 447 patent application discloses a composition comprising about 60 to 85% by weight of a polyhydric alcohol, about 5 to 40% by weight of a polar solvent, 0,5 to 10% by weight of fluoboric acid and the remainder being a fluorine containing compound.
US 7 129 029 patent discloses a formulation comprising PGME and large amount of water.

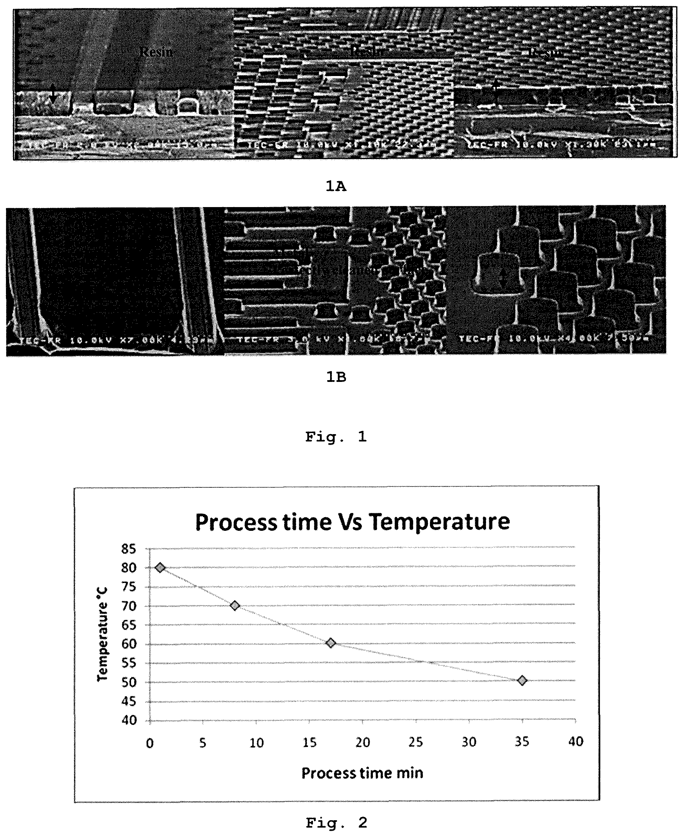

The object of the present invention is the formulation of a chemical containing as a principal solvent, two ether and/or polyether solvents, an acid and, optionally, surfactants, wherein the principal solvent goes into the formulation in proportions between 75% and 99.99% by mass in relation to the weight of the formulation, wherein the quantity of water added to the formulation is less than 1% by mass in relation to the total weight of the formulation and wherein the fraction of non-ether solvent is less than 10% by mass of the total weight of the solvents. The formulation enables the stripping by complete dissolution of photoresists, at temperatures between 40 and 100°C while ensuring total compatibility with exposed materials/metals (Figure 1). In addition, the singular cleaning properties and performance of these solutions make it possible to envisage the use thereof in a variety of industrial applications, such as in immersion and/or spraying processes by a simple adjustment of the time and temperature of the stripping process (Figure 2).

The invention thus relates to a formulation for the stripping by dissolution, advantageously by complete dissolution, of photoresists, comprising as a principal solvent, two ether and/or polyether solvents, and an acid, wherein the principal solvent goes into the formulation in proportions between 75% and 99.99% by mass in relation to the weight of the formulation, wherein the quantity of water added to the formulation is less than 1% by mass in relation to the total weight of the formulation and wherein the fraction of non-ether solvent is less than 10% by mass of the total weight of the solvents..

In the context of the present invention, the expression "complete dissolution" means that visually, after analysis by scanning electron microscopy (SEM), no more resin is observed on the substrate. The substrate is most often a silicon wafer comprising interconnections of metal (copper, aluminum), dielectrics (SiO₂, MSQ, etc.) and diffusion and adhesion barriers (TiN, Ti, Ta, TaN, etc.).

In the context of the present invention, the expression "total compatibility" means that the substrate is not damaged by the implementation of the method of the invention. In particular, no substrate corrosion is observed.

The inventive formulation advantageously enables the stripping by complete dissolution of positive or negative photoresists (g and/or i and/or h), more particularly semi-novolac resins. The photoresist will generally comprise one or more photosensitive compounds (diazonaphthoquinone (DNQ), for example) and polymers of semi-novolac resins (structural monomers: styrene, cresol-formaldehyde).

The resin can be positive or negative. As examples of negative resins, mention may be made of the commercial resins AZ®15nXT,AZ®nLOF2070, HNR80, KMPR1000, SC100, Nano™SU8, ma-N405, JSR-THB serie, NR5 serie, AZ®125nXT. As examples of positive resins, mention may be made of the commercial resins AZ®40XT, HPR500, OIR906, OIR620, micropositS1800, PR1 série, Megaposit™SPR™220 série, AZ®9260, AZ®4562, AZ®4533, AZ®4999.

The inventive formulation comprises, as a principal solvent, two ether and/or polyether solvents, optionally polyfunctionalized. The term "polyfunctionalized" refers to any chemical compound comprising within its molecule at least two distinct functional groups, for example ether/alcohol, ether/ester, ether/amine, ether/amide, amine/alcohol, ether/ether.

The principal solvent used in the present invention advantageously has a dielectric constant between 2 and 7 and a dipole moment less than 2.

The term "ether solvent" refers to any solvent of the form R-O-R', wherein R and R' are carbon chains. The chains R and R' can be aliphatic or aromatic, linear or branched, and optionally substituted. R and R' can be joined to form a ring.

According to an advantageous embodiment of the invention, R and R' represent, independently of one another, a linear or branched C₁-C₈ alkyl radical, advantageously a linear or branched C₁-C₄ alkyl radical, more advantageously a linear or branched C₁-C₄ alkyl radical, or a phenyl radical. R and/or R', advantageously only one of the two, is optionally substituted by one or more groups selected independently from the groups comprising -OH, -(CH₂)ₙ-OH, wherein n is an integer varying from 1 to 4, and -O(CO)-(CH₂)ₘ-CH₃, wherein m is an integer varying from 0 to 3. R and R' can be joined to form an aliphatic ring, optionally substituted by one or more groups selected from the group defined above.

"Polyether solvent" refers to any solvent that contains at least two ether functional groups.

According to a first embodiment, the polyether is of formula A-(O-B)ₚ-O-D wherein:
- A represents hydrogen, a linear or branched C₁-C₈ alkyl radical, optionally substituted by one or more alcohol groups -OH, a (CₓH₂ₓ₊₁-O-C_{y}H_{2y})_{z} radical with x and y independently represents an integer varying from 1 to 8 and z represents an integer varying from 1 to 6, or a C(O)R₁ radical wherein R₁ represents a linear or branched C₁-C₅ alkyl radical;
- B represents a linear or branched C₁-C₅ alkylene radical, and advantageously B represents -CH₂, -CH₂-CH₂, -CH₂-CH₂-CH₂, CH₂-CH(CH₃) or -CH₂-CH₂-CH₂-CH₂ ;
- p is an integer varying from 1 to 10;
- D represents hydrogen, a linear or branched C₁-C₆ alkyl radical, optionally substituted by one or more alcohol groups -OH, a (CₓH₂ₓ₊₁-O-C_{y}H_{2y})_{z} radical with x and y independently represents an integer varying from 1 to 8 and z represents an integer varying from 1 to 6;
- A and D can be joined to form an aliphatic ring optionally substituted by one or more groups selected independently from the groups comprising -OH, C₁-C₄ alkyl and -(CH₂)ₙ-OH, wherein n is an integer varying from 1 to 4, or a C(O)R₁ radical wherein R₁ represents a linear or branched C₁-C₅ alkyl radical.

More advantageously, the polyether is of formula A-(O-B)ₚ-O-D wherein:
- A represents hydrogen, a linear or branched C₁-C₆ alkyl radical, optionally substituted by one or more alcohol groups -OH, a (CₓH₂ₓ₊₁-O-C_{y}H_{2y})_{z} radical with x and y independently represents an integer varying from 1 to 6 and z represents an integer varying from 1 to 3,;
- B represents a linear or branched C₁-C₄ alkylene radical, and advantageously B represents -CH₂, -CH₂-CH₂, or CH₂-CH(CH₃) ;
- p is an integer varying from 1 to 10;
- D represents hydrogen, a linear or branched C₁-C₆ alkyl radical, optionally substituted by one or more alcohol groups -OH, a (CₓH₂ₓ₊₁-O-C_{y}H_{2y})_{z} radical with x and y independently represents an integer varying from 1 to 6 and z represents an integer varying from 1 to 3;
- A and D can be joined to form an aliphatic ring optionally substituted by one or more groups selected independently from the groups comprising -OH, C₁-C₄ alkyl and -(CH₂)ₙ-OH, wherein n is an integer varying from 1 to 4.

Still more advantageously, the polyether is of formula A-(O-B)ₚ-O-D:
- A represents hydrogen, a linear or branched C₁-C₆ alkyl radical, or a (CₓH₂ₓ₊₁-O-C_{y}H_{2y})_{z} radical with x and y independently represents an integer varying from 1 to 4 and z equals 1;
- B represents -CH₂, -CH₂-CH₂ or CH₂-CH(CH₃), advantageously methylene;
- p equals 1;
- D represents hydrogen, a linear or branched C₁-C₆ alkyl radical, or a (CₓH₂ₓ₊₁-O-C_{y}H_{2y})_{z} radical with x and y independently represents an integer varying from 1 to 4 and z equals 1.

More advantageously, D represents the same radical as A.

The polyether can also be a dibasic ester (DBE) of formula A-(O-B)_{q}-O-D wherein:
- A represents a C(O)R₁ radical wherein R₁ represents a linear or branched C₁-C₅ alkyl radical;
- B represents a linear or branched C₁-C₅ alkylene radical, and advantageously B represents -CH₂, -CH₂-CH₂, -CH₂-CH₂-CH₂, or -CH₂-CH₂-CH₂-CH₂;
- q equals 1;
- D represents a C(O)R₁ radical wherein R₁ represents a linear or branched C₁-C₅ alkyl radical.

According to a second embodiment, the polyether is of formula CH₂-O-(CH₂CH₂O)ᵣ-OCH₃ wherein r is an integer varying from 1 to 10.

The preferred solvents are selected from the group comprising linear or branched aliphatic ethers, cyclic ethers, aromatic ethers, glycol ethers, in particular glycol mono- or di-ethers, ethoxylated ethers and esters and polyfunctional ester ethers.

As examples of solvents, mention may be made of: carbitol (diethylene glycol monoethyl ether), dipropylene glycol monomethyl ether (DPGME), propylal (dipropoxymethane), butylal (dibutoxymethane),2,5,7,10-tetraoxaundecane, 2-ethylhexylal, dioxolane (1,3-dioxacyclopentane), 5-hydroxy-1,3-dioxane, 4-hydroxymethyl-1,3-dioxolane, tetrahydrofurfuryl alcohol, butyl diglycol, ethylethoxypropylene, diglyme (bis(2-methoxyethyl) ether), propylene glycol monomethyl ether acetate, propylene glycol monomethyl ether, anisole, β-diethylaminoethyl ethers, ethylene glycol phenyl ether, ethylene glycol n-butyl ether acetate, ethylene glycol ethyl ether acetate, polyglyme, ethylene glycol ethyl ether, dibasic ester (DBE) and dimethyl diethylene glycol ether.

More generally, mention may also be made of the following glycol ethers: ethylene glycol monomethyl ether, ethylene glycol monoethyl ether, ethylene glycol monobutyl ether, ethylene glycol dimethyl ether, ethylene glycol diethyl ether, diethylene glycol monomethyl ether, diethylene glycol monoethyl ether, diethylene glycol monopropyl ether, diethylene glycol monoisopropyl ether, diethylene glycol monobutyl ether, diethylene glycol monoisobutyl ether, diethylene glycol monohexyl ether, diethylene glycol monobenzyl ether, diethylene glycol dimethyl ether, diethylene glycol methyl ethyl ether, diethylene glycol diethyl ether, diethylene glycol dibutyl ether, triethylene glycol monomethyl ether, triethylene glycol dimethyl ether, propylene glycol monomethyl ether, propylene glycol monoethyl ether, propylene glycol dimethyl ether, propylene glycol monobutyl ether, propylene glycol monopropyl ether, dipropylene glycol monomethyl ether, dipropylene glycol monoethyl ether, dipropylene glycol monopropyl ether, dipropylene glycol monoisopropyl ether, dipropylene glycol monobutyl ether, dipropylene glycol mono tert-butyl ether, dipropylene glycol diisopropyl ether, dipropylene glycol dimethyl ether, tripropylene glycol monomethyl ether, ethylene glycol phenyl ether, ethylene glycol n-butyl ether acetate, ethylene glycol ethyl ether acetate, and mixtures thereof, in particular in pairs.

According to an advantageous embodiment of the invention, the solvent is selected from the group comprising methylal (dimethoxymethane), ethylal (diethoxymethane), propylal (dipropoxymethane), butylal (dibutoxymethane), dioxolane, glycerol formal, TOU (tetraoxaundecane), 2-ethylhexylal, and mixtures thereof, in particular in pairs. TOU is particularly preferred.

According to another embodiment, the principal solvent comprises advantageously two ethers such as defined above. In particular, the principal solvent is a mixture of:
- A solvent selected from the group comprising methylal (dimethoxymethane), ethylal (diethoxymethane), propylal (dipropoxymethane), butylal (dibutoxymethane), dioxolane, glycerol formal, TOU (tetraoxaundecane), 2-ethylhexylal, and mixtures thereof, in particular in pairs. TOU is particularly preferred.
- And a solvent selected from the group comprising glycol ethers, in particular selected from the group listed above. More particularly, the glycol ether is selected from the group comprising carbitol, DPGME, propylene glycol monomethyl ether acetate, propylene glycol monomethyl ether, ethylene glycol phenyl ether, ethylene glycol n-butyl ether acetate, ethylene glycol ethyl ether acetate, ethylene glycol ethyl ether, diethylene glycol dimethyl ether, and mixtures thereof, in particular in pairs. DPGME is preferred.

The use of this solvent mixture makes it possible to obtain formulations having both excellent properties of dissolution of photoresists, in particular semi-novolac resins, and a suitably low cost. Indeed, glycol ethers are most generally of low or reasonable cost. The other solvent, although more expensive, makes it possible to improve dissolution properties.

Without wanting to be bound by one such theory, the Inventors believe that the use of a solvent such as defined above enables, on the one hand, the expansion/swelling of the resin and, on the other hand, the dissolution of polymer fragments of the resin.

The principal solvent goes into the inventive formulation in proportions between 75% and 99.99% by mass, in relation to the weight of the formulation,.

In addition to this principal solvent, the formulation can comprise non-ether solvents. This non-ether solvent is easily hydrolysable, and in particular it is selected from dimethylacetamide (DMAC), N-methylpyrrolidinone (NMP), dimethylsulfoxide (DMSO), dimethylformamide, N-methylformamide, formamide, dimethyl-2-piperidone (DMPD), alcohols and mixtures thereof, in particular DMSO, alcohols and mixtures thereof.

As examples of alcohols, notable mention may be made of propylene glycol, glycol, benzyl alcohol and amino alcohols.

In a preferred embodiment, the non-ether solvent is DMSO.

The fraction of non-ether solvent is less than 10% by mass of the total weight of solvents (principal solvent + non-ether solvent), more advantageously 0%.

The total solvent content in the formulation varies advantageously in proportions between 75% and 99.99% by mass in relation to the weight of the formulation.

The inventive formulation comprises an acid. "Acid" refers to any compound that has the definition of a Lewis acid or a Bronsted acid.

In the context of the present invention, the acid must be completely soluble in the solvent or solvent mixture used in the formulation. The expression "completely soluble" means that more than 95% of the acid is solubilized in the solvent or solvent mixture, advantageously more than 99%, even more advantageously more than 99.5% (the percentages are expressed in moles in relation to the total number of moles of the acid).

The photopolymer breakdown step is essential to the mechanism by which the resin is solubilized by the solvent. This fundamental step is enabled by the presence of acid in the formulation.

This acid can be mineral (phosphoric acid, sulfuric acid, etc.) or organic (carboxylic acid, phosphonic acid, etc.).

According to an advantageous embodiment of the invention, the acid is selected from the group comprising
- acids of formula CH₂=CR"-COOH, wherein R" represents a hydrogen atom, a C₁-C₄ alkyl, -(CH₂)ₛ-COOH wherein s is an integer varying from 1 to 4;
- benzoic acid optionally substituted by a nitro or hydroxy radical ; advantageously the benzoic acid is substituted, preferably in the ortho position;
- oxalic acid, formic acid;
- phosphoric acid, sulfuric acid;
- etidronic acid (1-hydroxyethylidene-1,1-diphosphonic acid); and
- mixtures of these acids, in particular in pairs.

The acid is more particularly selected from the group comprising itaconic acid, acrylic acid, methacrylic acid, salicylic acid, etidronic acid (60% in particular), nitro-benzoic acid, oxalic acid, phosphoric acid, sulfuric acid, formic acid, and mixtures thereof, in particular in pairs. Oxalic acid is particularly preferred.

In addition to these preferred acids, the formulation can also comprise methanesulfonic acid.

The proportion by mass of acid in in the formulation will be adjusted according to the molecular weight and strength of the acid or the acids selected (pKa equivalent to the solvent).

The acid concentration in the formulation is advantageously between 0.01% and 25% by mass in relation to the total weight of the formulation, advantageously between 0.1% and 25% by mass.

In one embodiment of the invention, the acid is methanesulfonic acid, alone or in mixture with the above quoted acids. In such an embodiment, the solvent is not alcohol, meaning that the formulation is free of alcohol. Advantageously, in the same embodiment, the acid concentration in the formulation is between 0.01 and 10% by mass, 10% being excluded, in relation to the total weight of the formulation, more advantageously between 0.1 and 10% by mass, 10% being excluded, even more advantageously between 0.1 and 5% by mass.

In one embodiment of the invention, the inventive formulation also comprises one or more surfactants.

The solubilization rate of the resin can also be dependent on the surface tension at the polymer-substrate and resin-solution interface. It turns out that the presence of a surfactant can decrease resin-substrate and solution-resin interactions and prevent deposition of organic residues on the surface (front and back side of the plate) due to the surfactant's wetting, dispersing, detergent and emulsifying properties. Moreover, surfactants improve the solubilization of hydrophilic compounds in organic solvent. The preferred surfactants are, for example: ethoxylated and propoxylated fatty alcohols, ethoxylated terpenes, ethoxylated alkylphenols, ethoxy cetyl-oleyl alcohol, ethoxylated lauryl alcohol, ethoxylated isodecyl alcohol with a hydrophilic-lipophilic balance (HLB) value between 4 and 10. The quantity of surfactant, when present, is established between 0.01% and 15% by mass in relation to the total weight of the formulation.

In a preferred embodiment of the invention, the inventive formulation does not comprise a surfactant.

The inventive formulation is principally an organic solution. Indeed, the quantity of water added to the formulation is less than 1% by mass in relation to the total weight of the formulation, more advantageously it is zero. Advantageously, the formulation contains only water provided by the components used. The Inventors believe that the metal compatibility of the resin stripping solution is made possible by the very small quantity of water present in the medium (<1% by mass in relation to the total weight of the formulation), preventing/limiting metal dissociation and oxidation.

For cleaning processes that require working at high temperature (>70°C) and for long process times (>30 min), corrosion inhibitors could be added to the composition in order to guarantee complete compatibility of the metal elements. Such inhibitors will be selected, according to the metals to be protected, from inhibitors known by those persons skilled in the art such as triazole and derivatives, polyhydroxyl benzene and derivatives, phosphonate and derivatives, which can go into the composition in proportions between 0.01% and 2% by mass in relation to the total weight of the formulation. It has nevertheless been noted, in a surprising manner, that the presence of a corrosion inhibitor was most often not required, in particular when the acid used is oxalic acid, alone or in mixture with methanesulfonic acid. Preferentially, the inventive formulation does not comprise a corrosion inhibitor.

Contacting is carried out advantageously by immersion and/or spraying.

In the case of applications requiring the formation of complex structures deposited on a substrate, the thickness of the resin to be removed can vary from 1 to 300 microns.

The contacting step is advantageously implemented at temperatures between 40 and 100°C advantageously between 40 and 75°C, for a period of contact advantageously between 20 s and 60 min, advantageously between 20 s and 30 min, more advantageously between 20 s and 10 min.

The method of the invention enables complete dissolution of the resin, advantageously without having to repeat the contacting step.

The method of the invention comprises advantageously, following the contacting step, a substrate rinsing step. In one embodiment, the substrate is either cleaned directly with water or first with a solvent (isopropanol or acetone) and then with water. In most cases, since the inventive formulation is soluble in water, rinsing with water suffices. The duration of the rinsing step is most often less than 15 min, with 5 min being sufficient. The use of ultrasound is not necessary. Next, the substrate is dried.

Traditional batch equipment is well suited to the implementation of the method of the invention.

### Key to figures

Figure 1: SEM photographs taken on integrated industrial lines showing cleaning effectiveness and performance related to compatibility with exposed materials. The results were obtained on a semi-novolac resin (7 µm) deposited on a layer of copper.
Figure 1A: Before stripping.
Figure 1B: After stripping in the formulation of Example 1H for 20 min at 60°C in a static bath.
Figure 2: Rate of complete dissolution of resin as a function of process temperature. Results were obtained for a process by immersion in the formulation of Example 1H.

The examples that follow illustrate the present invention but do not limit it in any way.

### 1. Examples of formulation

• Example 1A

| | |
|---|---|
| - Dipropylene glycol monobutyl ether | 95% |
| - Formic acid | 5% |

• Example 1B

| | |
|---|---|
| - Tripropylene glycol monobutyl ether | 97% |
| - Methacrylic acid | 3% |

• Example 1C

| | |
|---|---|
| - Diethylene glycol monobutyl ether | 91% |
| - Itaconic acid | 9% |

• Example ID

| | |
|---|---|
| - Butyral | 60% |
| - Dipropylene glycol monobutyl ether | 35% |
| - Formic acid | 5% |

• Example 1E

| | |
|---|---|
| - 2,5,7,10-tetraoxaundecane | 65% |
| - Oxalic acid | 15% |
| - Water | 20% |

• Example 1F

| | |
|---|---|
| - Dipropylene glycol monobutyl ether | 96% |
| - Nitro-benzoic acid | 4% |

• Example 1G

| | |
|---|---|
| - Tripropylene glycol monomethyl ether | 90% |
| - Etidronic acid | 10% |

• Example 1H

| | |
|---|---|
| - 2,5,7,10-tetraoxaundecane | 59% |
| - Dipropylene glycol monomethyl ether | 39% |
| - Oxalic acid | 2% |

• Example 1I

| | |
|---|---|
| - 4-Hydroxymethyl-1,3-dioxolane | 49% |
| - Dipropylene glycol monomethyl ether | 49% |
| - Formic acid | 1% |

### 2. Dissolution performance

A copper substrate coated with AZ® 15nXT resin is placed in a beaker comprising either a formulation of the invention (as described in Example 1H), or a formulation containing DMSO/TMAH (tetra methyl ammonium hydroxide), or a formulation containing NMP (N-methyl-2-pyrrolidone).

**Table 1 - Processes undergone by the resin**

| Resin | AZ® 15nXT |
|---|---|
| Substrate | Cu |
| FT (film thickness) | 7 µm |
| SB (soft bake) | 110°C/180 s |
| Exposure | i-line |
| PEB (post exposition bake) | 120°C/60 s |
| DEV (development) | TMAH (AZ300MIF) |
| HB (hard bake) | None |

The resin is completely dissolved after 20 min of soaking at 60°C in the inventive formulation. An SEM analysis of the substrate shows no resin residue on the surface or attack on the metal. The residual liquid in the beaker does not comprise solid residues, which facilitates recycling of the solution.

In formulations containing DMSO/TMAH or NMP, insoluble residues are observed in the beaker after 3 hours of soaking.

### 3. Dissolution process

The formulation of Example 1H was used to strip the resins AZ® 40XT and AZ® nLOF 2070:

**Table 2 - Processes undergone by the resins**

| | AZ wafer | AZ wafer |
|---|---|---|
| Resin | AZ® nLOF 2070 | AZ® 40XT-11D |
| Substrate | Si | Si |
| FT | 6 µm | 24 µm |
| SB | 110°C/120 s | 126°C/100 s |
| Exposure | i-line | i-line |
| PEB | 100°C/60 s | 100°C/60 s |
| DEV | TMAH (AZ826MIF) | TMAH (AZ726MIF) |
| HB | 120°C/60 s | 120°C/30 min furnace |

The coated wafers were treated by immersion in the following formulation:

**Table 3 - Washing process**

| Resin | Temperature | Duration |
|---|---|---|
| AZ® 40XT (24 µm) | 65°C | <6 min |
| AZ® nLOF 2070 (6 µm) | 65°C | <6 min |

The wafers are then rinsed with water and then dried.

An SEM analysis of the substrate shows no resin residue on the surface or attacks on the metal.

### 4. Metal compatibility

The compatibility of the formulation of Example 1H was verified by immersion of various metals in the formulation at 65°C for 20 min. The results are summarized in the following table:

**Table 4 - Resistivity**

| Metal | Speed of etching expressed in angström/min determined by resistivity measurements according to the four-point probe test |
|---|---|
| Al (5% Cu) | <5 |
| Cu P.V.D. | <5 |
| Cu E.C.D. | <5 |
| Ni | <10 |
| Ta/TaN | 0 |
| Ti/TiN | <5 |
| Au | 0 |
| Thermal SiO₂ | 0 |
| Undoped Si | 0 |

Very high compatibility of the formulation with metals is thus noted.

## Claims

1. Formulation for the stripping by dissolution of photoresists, comprising as a principal solvent, two ether and/or polyether solvents, and an acid, wherein the principal solvent goes into the formulation in proportions between 75% and 99.99% by mass in relation to the weight of the formulation, wherein the quantity of water added to the formulation is less than 1% by mass in relation to the total weight of the formulation and wherein the fraction of non-ether solvent is less than 10% by mass of the total weight of the solvents.

2. The formulation of claim 1, **characterized in that** it comprises, as a principal solvent, at least one optionally polyfunctionalized ether and/or polyether solvent.

3. The formulation of claim 1 or claim 2, **characterized in that** the principal solvent has a dielectric constant between 2 and 7 and a dipole moment less than 2.

4. The formulation of any one of the preceding claims, **characterized in that** the principal solvent is selected from:
- an ether of formula R-O-R', wherein R and R' represent, independently of one another, a linear or branched C₁-C₈ alkyl radical, or a phenyl radical, optionally substituted by one or more groups selected independently from the groups comprising -OH, -(CH₂)ₙ-OH, wherein n is an integer varying from 1 to 4, and -O(CO)-(CH₂)ₘ-CH₃, wherein m is an integer varying from 0 to 3; R and R' can be joined to form an aliphatic ring, optionally substituted by one or more groups selected from the group defined above,
- a polyether of formula A-(O-B)ₚ-O-D wherein:
• A represents hydrogen, a linear or branched C₁-C₈ alkyl radical, optionally substituted by one or more alcohol groups -OH, a (CₓH₂ₓ₊₁-O-C_{y}H_{2y})_{z} radical with x and y independently represents an integer varying from 1 to 8 and z represents an integer varying from 1 to 6, or a C(O)R₁ radical wherein R₁ represents a linear or branched C₁-C₅ alkyl radical;
• B represents a linear or branched C₁-C₅ alkylene radical, and advantageously B represents -CH₂, -CH₂-CH₂, -CH₂-CH₂-CH₂, CH₂-CH(CH₃) or -CH₂-CH₂-CH₂-CH₂;
• p is an integer varying from 1 to 10;
• D represents hydrogen, a linear or branched C₁-C₆ alkyl radical, optionally substituted by one or more alcohol groups -OH, a (CₓH₂ₓ₊₁-O-C_{y}H_{2y})_{z} radical with x and y independently represents an integer varying from 1 to 8 and z represents an integer varying from 1 to 6;
• A and D can be joined to form an aliphatic ring optionally substituted by one or more groups selected independently from the groups comprising -OH, C₁-C₄ alkyl and -(CH₂)ₙ-OH, wherein n is an integer varying from 1 to 4;
- a polyether of formula CH₂-O-(CH₂CH₂O)ᵣ-OCH₃ wherein r is an integer varying from 1 to 10;
- and mixtures thereof.

5. The formulation of any one of the preceding claims, **characterized in that** the principal solvent is selected from the group comprising methylal (dimethoxymethane), ethylal (diethoxymethane), propylal (dipropoxymethane), butylal (dibutoxymethane), dioxolane, glycerol formal, TOU (tetraoxaundecane), 2-ethylhexylal, and mixtures thereof, in particular in pairs.

6. The formulation of any one of the preceding claims, **characterized in that** the principal solvent is a mixture of:
- A solvent selected from the group comprising methylal (dimethoxymethane), ethylal (diethoxymethane), propylal (dipropoxymethane), butylal (dibutoxymethane, dioxolane, glycerol formal, TOU (tetraoxaundecane), 2-ethylhexylal, and mixtures thereof, in particular in pairs,
- And a solvent selected from the group comprising glycol ethers, in particular selected from the group comprising carbitol, DPGME, propylene glycol monomethyl ether acetate, propylene glycol monomethyl ether, ethylene glycol phenyl ether, ethylene glycol n-butyl ether acetate, ethylene glycol ethyl ether acetate, ethylene glycol ethyl ether, diethylene glycol dimethyl ether, and mixtures thereof, in particular in pairs.

7. The formulation of any one of the preceding claims, **characterized in that** it comprises in addition to this principal solvent, one or more non-ether solvents, particularly DMSO.

8. The formulation of any one of the preceding claims, **characterized in that** the acid is selected from the group comprising
• acids of formula CH₂=CR"-COOH, wherein R" represents a hydrogen atom, a C₁-C₄ alkyl, -(CH₂)ₛ-COOH wherein s is an integer varying from 1 to 4;
• benzoic acid optionally substituted by a nitro or hydroxy radical; advantageously the benzoic acid is substituted, preferably in the ortho position;
• oxalic acid, formic acid;
• phosphoric acid, sulfuric acid;
• etidronic acid (1-hydroxyethylidene-1,1-diphosphonic acid); and
• mixtures of these acids, in particular in pairs.

9. The formulation of any one of the preceding claims, **characterized in that** the acid is selected from the group comprising itaconic acid, acrylic acid, methacrylic acid, salicylic acid, etidronic acid (60% in particular), nitro-benzoic acid, oxalic acid, phosphoric acid, sulfuric acid, formic acid, and mixtures thereof, in particular in pairs.

10. The formulation of any one of the preceding claims, **characterized in that** the acid concentration in the formulation is between 0.01% and 25% by mass in relation to the total weight of the formulation, advantageously between 0.1% and 25% by mass.

11. The formulation of any one of claims 1 to 7, **characterized in that** the acid is methylsulfonic acid, alone or in mixture with acids recited in claims 8 and 9, and the formulation is free of alcohol.

12. The formulation of any one of the preceding claims, **characterized in that** the formulation also comprises surfactants.

13. A method for cleaning a wafer substrate coated with at least one layer of one or more photoresists, comprising a step of contacting the substrate coated with a formulation of any one of the preceding claims.

14. The cleaning method of claim 13, **characterized in that** the photoresists are semi-novolac resins (structural monomers: styrene, cresol-formaldehyde).

15. The cleaning method of claim 13 or claim 14, **characterized in that** the contacting step is implemented at temperatures between 40 and 100°C advantageously between 40 and 75°C, for a contact time of between 20 s and 60 min, advantageously between 20 s and 30 min, more advantageously between 20 s and 10 min.

16. The cleaning method of claims 13 to 14, **characterized in that** it comprises subsequent steps of substrate rinsing and then drying.

## Patentansprüche

1. Formulierung zum Strippen von Fotolacks durch Auflösen, als Hauptlösungsmittel umfassend zwei Äther- und/oder Polyäther-Lösungsmittel und eine Säure, wobei das Hauptlösungsmittel in die Formulierung in Anteilen zwischen 75% und 99,99 Masse-% in Bezug auf das Gewicht der Formulierung eingeht, wobei die Menge an Wasser, die der Formulierung zugesetzt wird, kleiner als 1 Masse-% in Bezug auf das Gesamtgewicht der Formulierung ist und wobei der Anteil von Nicht-Äther-Lösungsmittel kleiner als 10 Masse-% des Gesamtgewichts der Lösungsmittel ist.

2. Formulierung nach Anspruch 1, **dadurch gekennzeichnet, dass** sie als Hauptlösungsmittel mindestens ein optional polyfunktionalisiertes Äther- und/oder Polyäther-Lösungsmittel umfasst.

3. Formulierung nach Anspruch 1 oder Anspruch 2, **dadurch gekennzeichnet, dass** das Hauptlösungsmittel eine dielektrische Konstante zwischen 2 und 7 hat und ein Dipolmoment von weniger als 2.

4. Formulierung nach einem der vorherigen Ansprüche, **dadurch gekennzeichnet, dass** das Hauptlösungsmittel ausgewählt wird aus:
- einem Äther der Formel R-O-R', wobei R und R' unabhängig voneinander ein lineares oder verzweigtes C₁-C₈-Alkylradikal oder ein Phenylradikal repräsentieren, optional substituiert durch eine oder mehrere Gruppen, die unabhängig ausgewählt werden aus den Gruppen, die -OH, -(CH₂)ₙ-OH umfassen, wobei n eine ganze Zahl ist, die von 1 bis 4 variiert, und -O(CO)-(CH₂)ₘ-CH₃, wobei m eine ganze Zahl ist, die von 0 bis 3 variiert; R und R' können verbunden werden, um einen aliphatischen Ring zu bilden, optional substituiert durch eine oder mehrere Gruppen, die aus der oben definierten Gruppe ausgewählt werden,
- einem Polyäther der Formel A-(O-B)ₚ-O-D, wobei:
• A Wasserstoff, ein lineares oder verzweigtes C₁-C₈-Alkylradikal repräsentiert, optional substituiert durch eine oder mehrere Alkoholgruppen -OH, ein (CₓH₂ₓ₊₁-CyH_{2y})_{z}-Radikal, wobei x und y unabhängig eine ganze Zahl repräsentieren, die von 1 bis 8 variiert, und z repräsentiert eine ganze Zahl, die von 1 bis 6 variiert, oder ein C(O)R₁-Radikal, wobei R₁ ein lineares oder verzweigtes C₁-C₅-Alkylradikal ist;
• B repräsentiert ein lineares oder verzweigtes C₁-C₅-Alkylenradikal, und vorteilhafterweise repräsentiert B -CH₂,-CH₂-CH₂, -CH₂-CH₂-CH₂, CH₂-CH(CH₃) oder -CH₂-CH₂-CH₂-CH₂ ;
• p ist eine ganze Zahl, die von 1 bis 10 variiert;
• D repräsentiert Wasserstoff, ein lineares oder verzweigtes C₁-C₆-Alkylradikal, optional substituiert durch eine oder mehrere Alkoholgruppen -OH, ein (CₓH₂ₓ₊₁-O-CyH_{2y})_{z}-Radikal, wobei x und y eine ganze Zahl repräsentieren, die von 1 bis 8 variiert, und z repräsentiert eine ganze Zahl, die von 1 bis 6 variiert;
• A und D können verbunden werden, um einen aliphatischen Ring zu bilden, optional substituiert durch eine oder mehrere Gruppen, die unabhängig aus den Gruppen ausgewählt werden, die -OH, C₁-C₄-Alkyl und -(CH₂)ₙ-OH enthalten, wobei n eine ganze Zahl ist, die von 1 bis 4 variiert;
- einen Polyäther der Formel CH₂-O-(CH₂CH₂O)ᵣ-OCH₃, wobei r eine ganze Zahl ist, die von 1 bis 10 variiert;
- und Mischungen derselben.

5. Formulierung nach einem der vorherigen Ansprüche, **dadurch gekennzeichnet, dass** das Hauptlösungsmittel aus der Gruppe ausgewählt wird, die Methylal (Dimethoxymethan), Ethylal (Diethoxymethan), Propylal (Dipropoxymethan), Butylal (Dibutoxymethan), Dioxolan, Glycerol-Formal, TOU (Tetraoxaundecan), 2-Ethylhexylal, und Mischungen derselben, insbesondere in Paaren, umfasst.

6. Formulierung nach einem der vorherigen Ansprüche, **dadurch gekennzeichnet, dass** das Hauptlösungsmittel eine Mischung von folgenden ist:
- Ein Lösungsmittel, das aus der Gruppe ausgewählt wird, die besteht aus Methylal (Dimethoxymethan), Ethylal (Diethoxymethan), Propylal (Dipropoxymethan), Butylal (Dibutoxymethan), Dioxolan, Glycerol-Formal, TOU (Tetraoxaundecan), 2-Ethylhexylal, und Mischungen derselben, insbesondere in Paaren,
- Und ein Lösungsmittel, das aus der Gruppe ausgewählt wird, die besteht aus Glycoläthern, insbesondere ausgewählt aus der Gruppe, die Carbitol, DPGME, Propylenglycolmonoethyletheracetat, Propylenglycolmonoethyläther, Ethylenglycolphenyläther, Ethylenglycol-n-butylätheracetat, Ethylenglycolethylätheracetat, Ethylenglycolethyläther, Diethylenglycoldimethyläther und Mischungen derselben, insbesondere in Paaren, umfasst.

7. Formulierung nach einem der vorherigen Ansprüche, **dadurch gekennzeichnet, dass** sie zusätzlich zu diesem Hauptlösungsmittel ein oder mehrere Nicht-Äther-Lösungsmittel umfasst, insbesondere DMSO.

8. Formulierung nach einem der vorherigen Ansprüche, **dadurch gekennzeichnet, dass** die Säure ausgewählt wird aus der Gruppe, die besteht aus:
• Säuren der Formel CH₂=CR"-COOH, wobei R" ein Wasserstoffatom, ein C₁-C₄-Alkyl, -(CH₂)ₛ-COOH repräsentiert, wobei s eine ganze Zahl ist, die von 1 bis 4 variiert;
• Benzoesäure, optional substituiert durch ein Nitro- oder Hydroxy-Radikal; vorteilhafterweise wird die Benzoesäure substituiert, vorzugsweise in der Orthoposition;
• Oxalsäure, Ameisensäure;
• Phosphorsäure, Schwefelsäure;
• Etidronsäure (1-Hydroxyethyliden-1,1-diphosphonsäure); und
• Mischungen dieser Säuren, insbesondere in Paaren.

9. Formulierung nach einem der vorherigen Ansprüche, **dadurch gekennzeichnet, dass** die Säure ausgewählt wird aus der Gruppe, die Itaconsäure, Acrylsäure, Methacrylsäure, Salicylsäure, Etidronsäure (insbesondere 60%), Nitrobenzoesäure, Oxalsäre, Phosphorsäure, Schwefelsäure, Ameisensäure und Mischungen derselben, insbesondere in Paaren, umfasst.

10. Formulierung nach einem der vorherigen Ansprüche, **dadurch gekennzeichnet, dass** die Säurekonzentration in der Formulierung zwischen 0,01% und 25 Masse-% in Bezug auf das Gesamtgewicht der Formulierung beträgt, vorzugsweise zwischen 0,1% und 25 Masse-%.

11. Formulierung nach einem der Ansprüche 1 bis 7, **dadurch gekennzeichnet, dass** die Säure Methylsulfonsäure ist, allein oder in Mischung mit Säuren, die in den Ansprüchen 8 und 9 angeführt wurden, und die Formulierung ist frei von Alkohol.

12. Formulierung nach einem der vorherigen Ansprüche, **dadurch gekennzeichnet, dass** die Formulierung auch Tenside umfasst.

13. Verfahren zum Reinigen eines Wafer-Substrats, das mit mindestens einer Schicht von einer oder mehreren Fotolacks beschichtet ist, das einen Schritt des Kontaktierens des Substrats umfasst, das mit einer Formulierung nach einem der vorherigen Ansprüche beschichtet ist.

14. Reinigungsverfahren nach Anspruch 13, **dadurch gekennzeichnet, dass** die Fotolacks Semi-Novolakharze (strukturelle Monomere: Styrol, Cresol-Formaldehyd) sind.

15. Reinigungsverfahren nach Anspruch 13 oder Anspruch 14, **dadurch gekennzeichnet, dass** der Kontaktierungsschritt bei Temperaturen zwischen 40 und 100°C implementiert wird, vorzugsweise zwischen 40 und 75°C, über eine Kontaktzeit zwischen 20 s und 60 min, vorteilhafterweise zwischen 20 s und 30 min, besser zwischen 20 s und 10 min.

16. Reinigungsverfahren nach Anspruch 13 bis 14, **dadurch gekennzeichnet, dass** es aufeinanderfolgende Schritte der Spülung und dann Trocknung des Substrats umfasst.

## Revendications

1. Formulation pour le décapage par dissolution de résines photosensibles, comprenant comme solvant principal, deux solvants d'éther et/ou de polyéther, et un acide, où le solvant principal entre dans la formulation dans des proportions entre 75 % et 99,99 % en masse par rapport au poids de la formulation, où la quantité d'eau ajoutée à la formulation est inférieure à 1 % en masse par rapport au poids total de la formulation et où la fraction de solvant non-éthéré est inférieure à 10 % en masse du poids total des solvants.

2. Formulation selon la revendication 1, **caractérisée en ce qu'**elle comprend, comme solvant principal, au moins un solvant d'éther et/ou polyéther éventuellement poly-fonctionnalisé.

3. Formulation selon la revendication 1 ou la revendication 2, **caractérisée en ce que** le solvant principal possède une constante diélectrique entre 2 et 7 et un moment dipolaire inférieur à 2.

4. Formulation selon l'une quelconque des revendications précédentes, **caractérisée en ce que** le solvant principal est choisi parmi :
- un éther de formule R-O-R', où R et R' représentent, indépendamment l'un de l'autre, un radical alkyle en C₁-C₈ linéaire ou ramifié, ou un radical phényle, éventuellement substitué par un ou plusieurs groupe(s) choisi(s) indépendamment parmi les groupes comprenant -OH, -(CH₂)ₙ-OH, où n est un entier variant de 1 à 4, et -O(CO)-(CH₂)ₘ-CH₃, où m est un entier variant de 0 à 3 ; R et R' peuvent être joints pour former un cycle aliphatique, éventuellement substitué par un ou plusieurs groupe(s) choisi(s) parmi le groupe défini ci-dessus,
- un polyéther de formule A-(O-B)ₚ-O-D où :
• A représente un atome d'hydrogène, un radical alkyle en C₁-C₈ linéaire ou ramifié, éventuellement substitué par un ou plusieurs groupe(s) alcool -OH, un radical (CₓH₂ₓ₊₁-O-C_{y}H_{2y})_{z}, x et y représentant indépendamment un entier variant de 1 à 8 et z représentant un entier variant de 1 à 6, ou un radical C(O)R₁ où R₁ représente un radical alkyle en C₁-C₅ linéaire ou ramifié ;
• B représente un radical alkylène en C₁-C₅ linéaire ou ramifié, et avantageusement B représente -CH₂, -CH₂-CH₂, -CH₂-CH₂-CH₂, CH₂-CH(CH₃) ou -CH₂-CH₂-CH₂-CH₂ ;
• p est un entier variant de 1 à 10 ;
• D représente un atome d'hydrogène, un radical alkyle en C₁-C₆ linéaire ou ramifié, éventuellement substitué par un ou plusieurs groupe(s) alcool -OH, un radical (CₓH₂ₓ₊₁-O-C_{y}H_{2y})_{z}, x et y représentant indépendamment un entier variant de 1 à 8 et z représentant un entier variant de 1 à 6 ;
• A et D peuvent être joints pour former un cycle aliphatique éventuellement substitué par un ou plusieurs groupe(s) choisi(s) indépendamment parmi les groupes comprenant -OH, alkyle en C₁-C₄ et -(CH₂)ₙ-OH, où n est un entier variant de 1 à 4 ;
- un polyéther de formule CH₂-O-(CH₂CH₂O)ᵣ-OCH₃ où r est un entier variant de 1 à 10 ;
- et des mélanges de ceux-ci.

5. Formulation selon l'une quelconque des revendications précédentes, **caractérisée en ce que** le solvant principal est choisi parmi le groupe comprenant le méthylal (diméthoxyméthane), l'éthylal (diéthoxyméthane), le propylal (dipropoxyméthane), le butylal (dibutoxyméthane), le dioxolane, le glycérol formal, le TOU (tétraoxaundécane), le 2-éthylhexylal et des mélanges de ceux-ci, notamment par paires.

6. Formulation selon l'une quelconque des revendications précédentes, **caractérisée en ce que** le solvant principal est un mélange :
- D'un solvant choisi parmi le groupe comprenant le méthylal (diméthoxyméthane), l'éthylal (diéthoxyméthane), le propylal (dipropoxyméthane), le butylal (dibutoxyméthane, le dioxolane, le glycérol formal, le TOU (tétraoxaundécane), le 2-éthylhexylal, et des mélanges de ceux-ci, notamment par paires,
- Et d'un solvant choisi parmi le groupe comprenant des éthers de glycol, notamment choisi parmi le groupe comprenant le carbitol, le DPGME, l'acétate d'éther monométhylique de propylène glycol, l'éther monométhylique de propylène glycol, l'éther phénylique d'éthylène glycol, l'acétate d'éther n-butylique d'éthylène glycol, l'acétate d'éther éthylique d'éthylène glycol, l'éther éthylique d'éthylène glycol, l'éther diméthylique de diéthylène glycol et des mélanges de ceux-ci, notamment par paires.

7. Formulation selon l'une quelconque des revendications précédentes, **caractérisée en ce qu'**elle comprend, en plus de ce solvant principal, un ou plusieurs solvant(s) non-éthéré(s), notamment le DMSO.

8. Formulation selon l'une quelconque des revendications précédentes, **caractérisée en ce que** l'acide est choisi parmi le groupe comprenant :
• des acides de formule CH₂=CR"-COOH, où R" représente un atome d'hydrogène, un alkyle en C₁-C₄, -(CH₂)ₛ-COOH où s est un entier variant de 1 à 4 ;
• un acide benzoïque éventuellement substitué par un radical nitro ou hydroxy ; avantageusement l'acide benzoïque est substitué, de préférence dans la position ortho ;
• l'acide oxalique, l'acide formique ;
• l'acide phosphorique, l'acide sulfurique ;
• l'acide étidronique (acide 1-hydroxyéthylidène-1,1-diphosphonique) ; et
• des mélanges de ces acides, notamment par paires.

9. Formulation selon l'une quelconque des revendications précédentes, **caractérisée en ce que** l'acide est choisi parmi le groupe comprenant l'acide itaconique, l'acide acrylique, l'acide méthacrylique, l'acide salicylique, l'acide étidronique (notamment 60 %), l'acide nitro-benzoïque, l'acide oxalique, l'acide phosphorique, l'acide sulfurique, l'acide formique et des mélanges de ceux-ci, notamment par paires.

10. Formulation selon l'une quelconque des revendications précédentes, **caractérisée en ce que** la concentration d'acide dans la formulation est comprise entre 0,01 % et 25 % en masse par rapport au poids total de la formulation, avantageusement entre 0,1 % et 25 % en masse.

11. Formulation selon l'une quelconque des revendications 1 à 7, **caractérisée en ce que** l'acide est l'acide méthylsulfonique, seul ou en mélange avec les acides cités dans les revendications 8 et 9, et la formulation est exempte d'alcool.

12. Formulation selon l'une quelconque des revendications précédentes, **caractérisée en ce que** la formulation comprend également des tensioactifs.

13. Procédé de nettoyage d'une plaquette revêtue d'au moins une couche d'une ou plusieurs résine(s) photosensible(s), comprenant une étape de mise en contact du substrat revêtu d'une formulation selon l'une quelconque des revendications précédentes.

14. Procédé de nettoyage selon la revendication 13, **caractérisé en ce que** les résines photosensibles sont des résines semi-novolac (monomères structuraux : styrène, crésol-formaldéhyde).

15. Procédé de nettoyage selon la revendication 13 ou la revendication 14, **caractérisé en ce que** l'étape de mise en contact est mis en oeuvre à des températures comprises entre 40 et 100 °C, avantageusement entre 40 et 75 °C, pour un temps de contact entre 20 s et 60 min, avantageusement entre 20 s et 30 min, plus avantageusement entre 20 s et 10 min.

16. Procédé de nettoyage selon les revendications 13 à 14, **caractérisé en ce qu'**il comprend des étapes ultérieures de rinçage puis séchage de la plaquette.
